# EUROPEAN PATENT SPECIFICATION

(11) **EP 0 529 577 B1**
(45) Date of publication and mention of the grant of the patent: **09.10.1996**
(21) Application number: 92114444.0
(22) Date of filing: 25.08.1992
(51) Int. Cl.: G01R 1/073, H05K 3/20, H05K 3/40

(54) **Electrical test probe having shaped contacts**
Elektrischer Messfühler mit geformten Kontakten
Tête de mesure électrique comprenant des contacts formés

(30) Priority: 26.08.1991 US 750842; 30.08.1991 US 753400
(43) Date of publication of application: 03.03.1993
(73) Proprietor: Hughes Aircraft Company, Los Angeles, California 90045-0066 (US)
(72) Inventor: Feigenbaum, Haim, Irvine, California 92715 (US); Crumly, William R., Anaheim, California 92807 (US); Schreiber, Christopher M., San Clemente, California 92672 (US)
(74) Representative: Weller, Wolfgang, Dr.rer.nat.

(56) References cited:
- WO-A-90/10320
- US-A- 3 350 250
- US-A- 4 125 441
- US-A- 4 374 708
- US-A- 4 878 294
- RESEARCH DISCLOSURE no. 319, November 1990, HAVANT GB , XP160172 31947: 'Fixed probe test adapter'

## Description

The present invention relates to a method of testing an integrated circuit and an electrical test probe.

A fixed probe test adapter comprising conically shaped test probes affixed to pads is disclosed in Research Disclosure No. 319, November 1990, Emsworth, GB.

Both flexible and rigid circuits including integrated circuits are connected to similar circuits and other components, or to testing devices, by means of various types of connecting devices. Flat, flexible printed circuit connecting cables warrant use of similarly configured connecting devices and have been developed to a point where connection between one such printed circuit cable and another circuit is made by providing a plurality of projecting metallic interconnection features ("dots") that may be pressed against either similar features or mating metallic connecting pads on the other circuit component or components. Flexible circuit terminations or connecting wafers of this type are described in U. S. Patent No. 4,125,310 to Patrick A. Reardon, II, U. S. Patent No. 4,116,517 to Selvin et al, and U. S. Patent No. 4,453,795 to Moulin, et al. The connectors of these patents embody a substrate having traces chemically milled thereon with a plurality of metallic raised features later formed to project from the plane of the circuit connectors. Thus, when two such connectors are placed face to face with the raised features of one in registration and contact with the other, the planes of the etched electrical circuits are suitably spaced from one another because of the projection of the features. The two circuits may be physically clamped together to press the features against one another, thereby making firm and intimate electrical contact between the two circuits.

These termination arrangements are effective and reliable in operation but difficult, costly and time consuming to manufacture. Major problems in manufacture of such connectors derive from the fact that the projecting contact buttons must be fabricated separately from (either before or after) the fabrication of the circuitry itself. This creates difficult registration problems. For example, after drilling appropriate interconnection and tooling holes through a copper clad dielectric core or substrate and plating through some of the holes to interconnect circuitry on the two sides of the core, the core is placed between the circuit artwork (optical masks) positioned on either side of the core and the holes in the artwork or datum points are then manually aligned with the predrilled holes in the core. Where dozens of parts may be made on a single panel that is 304,8 mm × 457,2 mm (12" x 18"), and alignment tolerances are measured within a few microns, registration of all or even most holes in all of the parts is exceedingly difficult, time consuming and often times not possible because of changes in dimensions of the panels following some of the processing operations. After registration of the artwork, the substantially planar circuitry is chemically milled or etched on the copper surfaces (the panel may often be covered with a coating of copper on both sides for a double sided panel). The etching process involves application of photoresist, masking the resist, exposing the resist, developing the resist, then etching through the portions of the copper not protected by the resist so that upon stripping of the remaining resist, the circuit pattern of the copper conductors remains.

Where raised interconnection features are employed, it is then necessary to plate the projecting contact features on pads formed in the circuitry which has been previously etched. These features must be precisely registered with the selected pads and with the datum of the panel. However, the panels have been previously processed to form the circuit traces so that further stresses occurring in such processing effect changes in dimension (usually, but not always, shrinkage). The changing dimensions cause severe registration problems. To manufacture the projecting contact features (sometimes called "dots"), the etched circuit is coated with a resist. Again, the appropriate artwork for defining the desired hole in the resist at the dot location must be carefully registered, which is now an even more difficult task.

In some cases, the projecting interconnection features or dots may be formed first, before the remainder of the etched circuit is formed. But, in any event, the feature must be formed separately, at a different time than the time of forming the etched circuitry, and thus the registration problems are created or exacerbated.

In such circuits, where a connection must be made from circuitry on one side of the core to circuitry on the other side of the core, holes are drilled and through-hole plated, requiring still further steps and creating other registration problems that increase cost and time of manufacture.

Conventional etched circuit processes, in general, have a number of disadvantages. Dimensional precision is difficult to achieve. The use of various etching, stripping and cleaning fluids requires special handling of hazardous chemicals. Techniques for disposal of the resulting effluents are complex and expensive, and subject to strict government controls. Etched circuit processing has a relatively low yield, greatly increasing the cost of the processing, which inherently involves a large number of costly processing steps.

Regardless of the manner in which the connections are made, it is frequently necessary to impart a type of wiping or abrasive action when one circuit is actually being connected to another so as to ensure a good electrical contact. This is so because circuits pads of many different types of materials are subject to accumulation of foreign poorly conductive materials on the contact surfaces. Thus, tin, silver, aluminum and copper contact elements, among others, will experience relatively rapid oxidation, so as to form oxide layers which tend to degrade electrical contacts made at such oxidized surface.

For this reason, gold to gold contacts are employed to eliminate the oxidation problems and improve the making of electrical contacts between several circuits. The need to use expensive gold coatings on the contacts can be avoided by use of an abrasive or wiping action when the contact is made. The wiping action physically abrades the foreign surface or oxide coating at the time of making the contact.

Gold coatings are expensive and may often require an additional processing step. The need for a wiping action can increase the cost and complexity of connecting equipment. Moreover, wiping action to ensure good contact may not be available with many different types of test probes, which are used for testing integrated circuits on a wafer before the circuits are separated from one another. In the testing of such circuits, contacts of the test probe are moved so as to touch contact pads on the integrated circuit under test, and often only a pressure action is available without any type of wiping. For this reason, it frequently happens that a desired electrical connection between a test probe contact and a contact pad on the circuit under test is not adequately made, or is not made at all, thereby degrading test results.

Accordingly, it is an object of the present invention to provide for connection between electrical circuits while avoiding or minimizing above mentioned problems.

According to the invention this object is achieved with a method of testing an integrated circuit having a pattern of contact pads, said method comprising the steps of:
providing a substrate,
forming on said substrate a circuit having a plurality of connector pads, at least a group of said connector pads having a pointed contact feature, in a pattern that matches said pattern on said integrated circuit contact pads,
wherein said pointed contact features have been integrally electroformed with their respective connector pads, and
pressing said pointed contact features against said integrated circuit pads.

Further, according to the invention an electrical test probe comprises a dielectric substrate, a plurality of circuit traces on the substrate having contact pads, and a pointed raised contact on each of said contact pads, said raised contacts each projecting from a circuit trace contact pad and terminating in a free end of reduced area, wherein each said pointed raised contact is integrally electroformed with its contact pad.

In carrying out principles of the present invention in accordance with a preferred embodiment thereof electrical connections are made by means of uniquely shaped projecting contacts formed on circuit traces of the test probe to be connected to another circuit. In a first set of embodiments, the shaped contacts are effectively pointed at their free ends, being of either conical, truncated conical, pyramidal or truncated pyramidal shape, so as to provide small area contact ends that will concentrate the contact forces and more readily penetrate surface layers of foreign materials and make contact to pads on the mating circuit.

According to another embodiment of the invention, shaped contacts are provided with a semi-spherical end so that when a sliding or lateral wiping action is employed to ensure good contact, a slight misalignment of the contacts may be tolerated without causing a sharp edge of the contact to dig into and damage the pad against which the contact is pressed.

In the accompanying drawings:
FIG. 1 illustrates a preliminary step in the manufacture of a circuit having shaped contacts;
FIGS. 2 through 5 illustrate side and plan views, respectively, of two differently shaped tools for use in forming depressions in a circuit manufacturing mandrel;
FIG. 6 illustrates a further step in the manufacture of the shaped contact bearing circuit;
FIG. 7 shows a circuit including a substrate having conductive traces and shaped connective features thereon; and
FIG. 8 illustrates the connection of a circuit with the shaped connections to another circuit.

The methods and apparatus described herein enable the manufacture of electrical test probes with uniquely shaped contact features, wherein the circuits lie in a single plane, with the contact features projecting from such plane. The projecting features and circuitry are all electroformed which is an additive process. No etching is formed in the manufacture of the circuit, thereby making it an environmentally safe process.

Briefly, the circuit is manufactured by using a mandrel having a working surface that is formed of a material that can have conductive circuitry electroformed thereon and which has a pattern of material that is resistant to the electroforming process. The mandrel is formed with a depression of a predetermined configuration that will produce an electroformed projecting shape contact having the configuration of the depression.

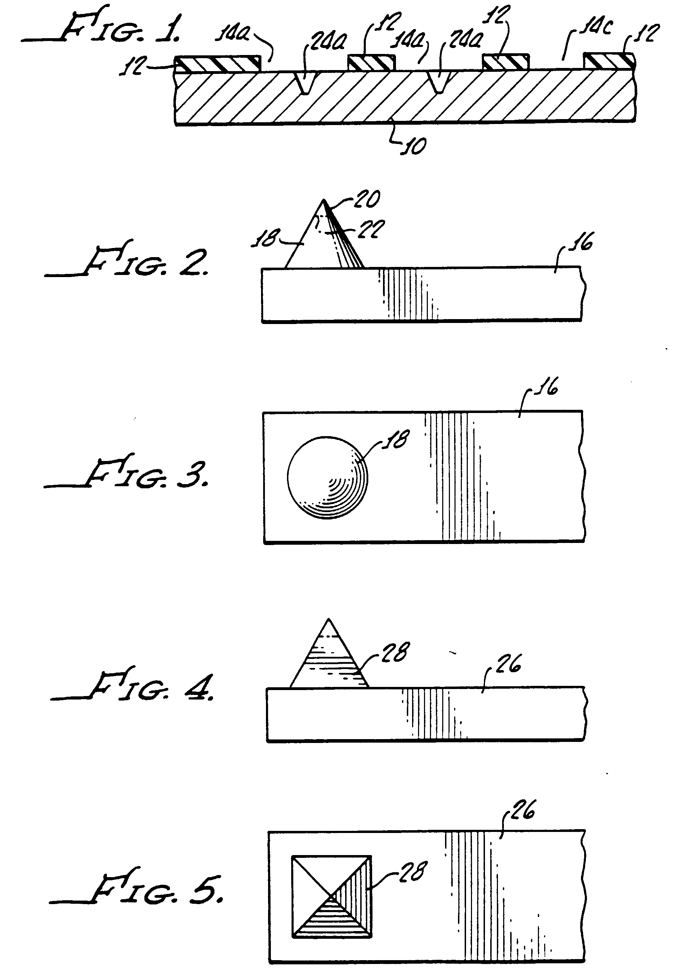

As illustrated in the cross section of the fragmentary view of FIG. 1, a mandrel 10 is formed of a sheet of metal, such as a stainless steel having a thickness on the order of 1/16 of an inch (1 inch = 25,4 mm) for example, and having dimensions suitable for making one or a plurality of parts. In one method for fabricating a mandrel with raised features (e.g. a depression) the stainless steel mandrel 10 is initially provided with a non-conductive coating, such as Teflon 12, which is then ablated, as shown in FIG. 1, as by use of a laser, for example, to form a positive pattern of grooves, such as grooves 14a, 14b and 14c in the Teflon. The pattern of grooves exposes the conductive surface of the stainless steel mandrel and leaves a negative pattern of the electrically non-conductive Teflon on the mandrel working surface.

The method described to this point, and certain other steps to be described hereinafter, are similar to methods described in a co-pending application for Three-Dimensional Electroformed Circuitry, invented by William R. Crumly, Christopher M. Schreiber and Haim Feigenbaum, US-A-5 197 184, which was published after the priority date of the present application.

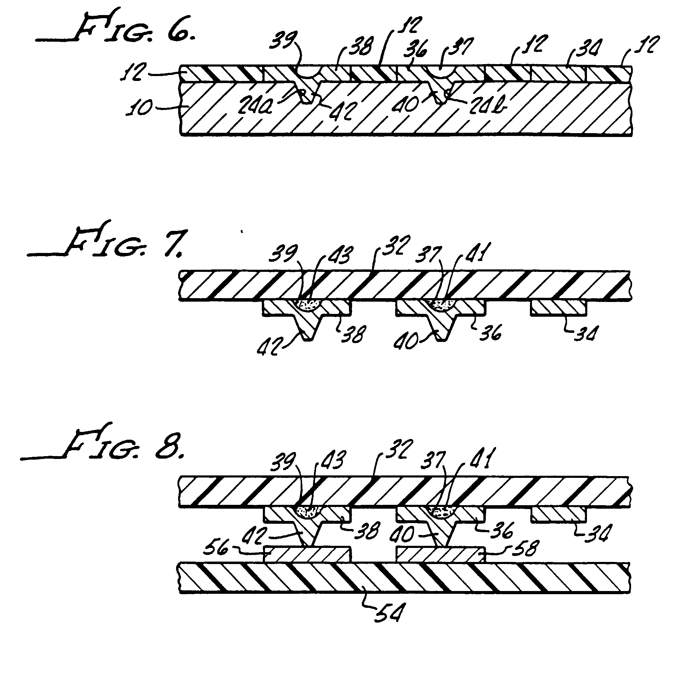

In the identified co-pending application, one or more depressions 24a, 24b are formed in the surface of the stainless steel mandrel 10 at areas, such as 14a and 14b, by means of photolithographic processes, employing a suitable photoresist coating, which is masked, exposed and developed, and then subjecting the mandrel to an etching bath to form the depression on the working surface of the mandrel. However, control of the shape of the depression is a significant feature of the present invention. Adequate control of this shape is not possible with the prior etching process. Therefore, in order to more precisely control the shape of the depressions 24a and 24b to any one of a number of different predetermined shapes, there is used an indentation tool, such as that shown for example in FIGS. 2 and 3. This tool includes a hardened steel base 16 and a shaped tapered projection 18 that is fixedly secured by any suitable means to the base 16. The projection 18 may be a pin fixed to the base that has been ground or otherwise machined to provide the illustrated shape. For the indentation tool shown in FIGS. 2 and 3 the shape of the indenting feature 18 of the tool is a cone, having a predetermined cone angle. Tool 16 is used to form the indentations 24a, 24b in the surface of the mandrel 10, as, for example, by mounting the tool on a carriage (not shown) supported over the mandrel for precision motion in orthogonal X and Y directions. The tool and its indentation feature, which is pointing down toward the mandrel, are moved to a predetermined position and then the hardened tool and its tapered indentation feature are pressed against the mandrel to form the indentation. The tool is then raised and precisely moved to a second location, and a second indentation is formed. This procedure is repeated. Thus, a group of indentations are formed on the mandrel in any given pattern, with the location of the several indentations precisely positioned according to the degree of precision available from the X,Y drive of the tool carrying carriage.

For an alternate tapered contact configuration, the tip 20 of the projecting feature 18 may be removed, as by grinding, clipping or the like, to provide a shape of projection feature having a tapered body and a very small area flat surface on its free end. The small area, substantially a flat free end, is illustrated by the dotted line in FIG. 2.

For use of the tapered contacts in connecting two integrated circuits to one another, the tapered indentations (the tapered indentations 24a and 24b of the mandrel have the same dimensions as the tapered projection 18 on the tool) may have a base of about 10 mils in diameter, a tip area of about 5 mils diameter, and the height of the projection 18 may be 8 mils. Where the projecting features are used as contacts on a test probe they may be made considerably smaller so that the base of the projection may be in the order of 2 to 3 mils, with the top area having a diameter of about 1.0 mils. In such a test probe fixture the height of the tapered projecting contacts may be 1/2 to 4 mils (1 mil = 25,4 µm).

In an alternate tooling configuration for making an indentation of a slightly varied shape (FIGS. 4 and 5), the hardened tool steel base plate 26 is formed with a rigid tapered pyramidal projection 28 fixedly secured thereto. While the drawing shows a pyramid with a base that is square, other shapes may be used (such as diamond). A different number of sides (such as three, forming a tetrahedron) may be used. Just as with the conical tapered projection feature 18, the pyramidal projection, if deemed necessary or desirable, may have a portion of its tip removed to provide a small area tip at its free end.

After having the hardened steel indentation has formed a number of depressions 24a, 24b, etc. in predetermined areas of the stainless steel mandrel 10 that are not covered by Teflon 12, the mandrel with its depressions, is subjected to an electroforming processing such as electrolytic plating to electrodeposit a layer of copper or other suitable conductive material over the entire exposed conductive surface of the mandrel. Depending on the thickness of the electroplated layer of conductive material 34,36 and 38 of copper or the like, a depression, such as depressions 37,39 (FIG. 6) will be formed in the pads 36,38, which create a tapered projection feature that lines the depression and is effectively hollow to some extent. For small projection features, subsequent lamination steps will fill the feature with dielectric material. For larger features these depressions may be filled with an epoxy 41,43 (FIG. 7) that hardens to a solid to strengthen the resulting projecting contact. Steps in the processing of the circuit that follow are the same as those described in the aforementioned co-pending application for Three-Dimensional Electroformed Circuitry. These following steps include the lamination of a dielectric substrate 32 to the subassembly of mandrel, Teflon and circuit traces of FIG. 6. Thereafter the assembly of substrate 32, together with the circuit traces 34 and pads 36,38 with their tapered projecting contacts 40,42, are removed as a unit from the mandrel 10 to result in the assembly illustrated in FIG. 7. An insulating coverlay may then be deposited over the exposed circuitry, leaving tips of the projections free of the insulation.

FIG. 8 illustrates application of the described shaped contacts for use in a test probe. FIG. 8 shows a part of a test probe as including the dielectric substrate 32 with its pattern of circuit traces illustrated by trace 34, and its pattern of pointed connecting contacts illustrated in FIG. 8 by contacts 40 and 42. An integrated circuit wafer 54, having a plurality of test contact pads 56,58, is brought into close proximity to the test probe, with the contact pads 56,58 of the wafer 54 in registration with the corresponding pattern of tapered pointed contact features 40,42. The test probe is then pressed against the wafer to cause the pointed test probe contacts 40,42 to penetrate at their pointed free ends any surface contamination or oxide layer on the surface of contacts 54,56 to form a good electrical contact between the test probe and the integrated circuit wafer 54. No wiping action is required in this arrangement, since the pointed, small area ends of the conical or pyramidal shaped contacts 40,42 readily provide a sufficiently high unit pressure at the surface of contact test pads 56,58 to penetrate any oxide or other foreign layer. If deemed necessary or desirable, hard gold coated over nickel or other coatings of superior wear resistance and similar oxidation resistance may be employed to coat the probe contacts 40,41.

There have been described circuits having fixed shaped contacts where the shapes are uniquely adapted for improving electrical contact without requiring any wiping action for good electrical connections. The contacts may be made in any suitable predetermined shape by use of an appropriately shaped indentation tool. Useful shapes include conical and pyramidal shapes, including truncated versions of these, and also spherical or near spherical shapes or bullet shapes that permit a conventional wiping action while tolerating some misalignment of contacts.

To summarize, shaped contacts 40, 42 for interconnecting circuits or for use in an integrated circuit test probe are electroplated as integral parts of circuit traces 34 upon a stainless steel mandrel 10. A shaped, hardened steel indentation tool 16, 18, 26, 28 makes indentations 24a, 24b of predetermined shape in the surface of the mandrel 10, which is provided with a pattern of dielectric, such as Teflon 12, or photoresist. Areas of the steel mandrel, including the indentations 24a, 24b, are electroplated with a pattern of conductive material 34, 36, 38, and a dielectric substrate 32 is laminated to the conductive material. The circuit features formed by the indentations define raised contacts of a conical 18 or pyramidal 28 shape, having free ends with a small area that allows higher pressures to be applied to a surface against which the contacts are pressed. This enables the contacts to penetrate foreign materials, such as oxides, that may form on the surface of the pads 56, 58, to which the contacts are to be connected to ensure a good contact without any need for wiping action.

## Claims

1. Method of testing an integrated circuit having a pattern of contact pads (56, 58), said method comprising the steps of:
providing a substrate (32),
forming on said substrate (32) a circuit having a plurality of connector pads (34, 36, 38), at least a group (36, 38) of said connector pads (34, 36, 38) having a pointed contact feature (40, 42), in a pattern that matches said pattern on said integrated circuit contact pads (56, 58),
wherein said pointed contact features (40, 42) have been integrally electroformed with their respective connector pads (36, 38); and
pressing said pointed contact features (40, 42) against said integrated circuit pads (56, 58).

2. Method according to claim 1, characterized in that the contact feature (40, 42) is electroformed as a tapered body (18, 28) having a truncated end (20) that provides a small substantially flat contact area.

3. Method according to claim 1, characterized in that said contact feature (40, 42) has a conical shape (18) with a truncated tip.

4. Method according to claim 1, characterized in that said contact feature (40, 42) has a pyramidal shape (28) with a truncated tip.

5. Electrical test probe comprising:
a dielectric substrate (32),
a plurality of circuit traces (34) on the substrate (32) having contact pads (34, 36, 38), and
a pointed raised contact (40, 42) on each of said contact pads (36, 38), said raised contacts (40, 42) each projecting from a circuit trace contact pad (36, 38) and terminating in a free end of reduced area,
wherein each said pointed raised contact (40, 42) is integrally electroformed with its contact pad (36, 38).

6. Electrical test probe according to claim 5, characterized in that each said contact (40, 42) has a free end adapted to touch a circuit element (56, 58) to be connected to said test probe, and wherein each said contact (40, 42) tapers from a relatively large area base at its contact pad (36, 38) to a relatively small area at its free end that is capable of penetrating a layer of poor conductivity on the surface of a circuit element (56, 58) to be connected to said test probe.

7. Electrical test probe according to claim 5 or claim 6, characterized in that each of said contacts (40, 42) has a free end and wherein each contact (40, 42) is conical (18) and tapers to a point at its free end.

8. Electrical test probe according to claim 5 or claim 6, characterized in that each of said contacts (40, 42) has a free end and wherein each contact (40, 42) is pyramidal (28) and tapers to a surface of reduced dimension at its free end.

## Patentansprüche

1. Verfahren zum Testen einer integrierten Schaltung mit einem Muster von Kontaktflecken (56, 68), wobei das Verfahren die Schritte umfaßt:
Bereitstellen eines Substrates (32),
Ausbilden einer eine Vielzahl von Anschlußflecken (34, 36, 38) aufweisenden Schaltung auf dem Substrat (32) und in einem Muster, das dem Muster der Kontaktflecken (56, 58) auf der integrierten Schaltung entspricht, wobei wenigstens eine Gruppe (36, 38) der Anschlußflecken (34, 36, 38) ein spitzes Kontaktteil (40, 42) aufweist,
wobei die spitzen Kontaktteile (40, 42) einstückig mit ihren entsprechenden Anschlußflecken (36, 38) durch elektrische Abscheidung ausgebildet wurden; und
Pressen der spitzen Kontaktteile (40, 42) gegen die Flecken (56, 58) der integrierten Schaltung.

2. Verfahren nach Anspruch 1, dadurch gekennzeichnet, daß das Kontaktteil (40, 42) durch elektrisches Abscheiden als ein sich verjüngender Körper (18, 28) mit einem abgestumpften Ende (20) ausgebildet ist, das einen kleinen, im wesentlichen flachen Kontaktbereich darstellt.

3. Verfahren nach Anspruch 1, dadurch gekennzeichnet, daß das Kontaktteil (40, 42) eine konische Form (18) mit einer abgestumpften Spitze aufweist.

4. Verfahren nach Anspruch 1, dadurch gekennzeichnet, daß das Kontaktteil (40, 42) eine Pyramidenform (28) mit einer abgestumpften Spitze aufweist.

5. Elektrischer Testkopf, mit:
einem dielektrischen Substrat (32),
einer Vielzahl von Kontaktflecken (34, 36, 38) aufweisenden Schaltungsbahnen (34) auf dem Substrat (32), und
einem spitzen, erhabenen Kontakt (40, 42) an jedem der Kontaktflecken (36, 38), wobei die erhabenen Kontakte (40, 42) jeweils von einem Kontaktflecken (36, 38) der Schaltungsbahnen vorstehen und in einem freien Ende mit verringerter Fläche enden,
wobei jeder der spitzen, erhabenen Kontakte (40, 42) einstückig mit seinem Kontaktflecken (36, 38) durch elektrische Abscheidung ausgebildet wurde.

6. Elektrischer Testkopf nach Anspruch 5, dadurch gekennzeichnet, daß jeder Kontakt (40, 42) ein freies Ende aufweist, das dazu angepaßt ist, ein Schaltungselement (56, 58) zu berühren, das mit dem Testkopf verbunden werden soll, wobei jeder Kontakt (40, 42) sich von einer Basis mit relativ großer Fläche an seinem Kontaktflecken (36, 38) zu einer relativ kleinen Fläche an seinem freien Ende verjüngt, das in eine Schicht geringer Leitfähigkeit an der Oberfläche eines Schaltungselementes (56, 58) eindringen kann, das mit dem Testkopf verbunden werden soll.

7. Elektrischer Testkopf nach Anspruch 5 oder Anspruch 6, dadurch gekennzeichnet, daß jeder der Kontakte (40, 42) ein freies Ende aufweist, wobei jeder Kontakt (40, 42) konisch (18) ist und sich zu einem Punkt an seinem freien Ende hin verjüngt.

8. Elektrischer Testkopf nach Anspruch 5 oder Anspruch 6, dadurch gekennzeichnet, daß jeder der Kontakte (40, 42) ein freies Ende aufweist, wobei jeder Kontakt (40, 42) pyramidenförmig (28) ist und sich zu einer Fläche mit verringertem Abmaß an seinem freien Ende hin verjüngt.

## Revendications

1. Procédé pour tester un circuit intégré possédant un réseau de plots de contact (56,58), ledit procédé comprenant les étapes consistant à :
prévoir un substrat (32),
former sur ledit substrat (32) un circuit possédant une pluralité de plots de connexion (34,36,38), au moins un groupe (36,38) desdits plots de connexion (34,36, 38) possédant un élément caractéristique de contact pointu (40,42), sous la forme d'un réseau qui concorde avec ledit réseau de plots de contact (56,58) dudit circuit intégré,
lesdits éléments caractéristiques de contact pointu (40,42) ayant été électroformés d'un seul tenant avec leurs plots respectifs de connexion (36,38) ; et
repousser lesdits éléments caractéristiques de contact pointu (40,42) contre lesdits plots (56,58) du circuit intégré.

2. Procédé selon la revendication 1, caractérisé en ce que l'élément caractéristique de contact (40,42) est électroformé sous la forme d'un corps conique (18,28) possédant une extrémité tronquée (20) qui forme une petite surface de contact essentiellement plate.

3. Procédé selon la revendication 1, caractérisé en ce que ledit élément caractéristique de contact (40,42) possède une forme conique (18) possédant une pointe tronquée.

4. Procédé selon la revendication 1, caractérisé en ce que ledit élément caractéristique de contact (40,42) possède une forme pyramidale (28) avec une pointe tronquée.

5. Sonde de test électrique comprenant :
un substrat diélectrique (32),
une pluralité de pistes de circuit (34) sur le substrat (32) comportant des plots de contact (34,36,38), et
un contact pointu surélevé (40,42) situé sur chacun desdits plots de contact (36,38), lesdits contacts surélevés (40,42) faisant saillie chacun à partir d'un plot de contact (36,38) des pistes du circuit et se terminant par une extrémité libre de surface réduite,
chacun desdits contacts surélevés pointus (40,42) étant électroformé d'un seul tenant avec son plot de contact (36,38).

6. Sonde de test électrique selon la revendication 5, caractérisée en ce que chacun desdits contacts (40,42) possède une extrémité libre adaptée pour être en contact avec un élément de circuit (56,58) devant être connecté à ladite sonde de test, et dans laquelle chacun desdits contacts (40,42) se rétrécit à partir d'une base de surface relativement étendue au niveau de son plot de contact (36,38) jusqu'à une surface relativement petite située au niveau de son extrémité libre, qui est capable de pénétrer dans une couche de faible conductivité située sur la surface d'un élément de circuit (56,58) devant être connecté à ladite sonde de test.

7. Sonde de test électrique selon la revendication 5 ou la revendication 6, caractérisée en ce que chacun desdits contacts (40,42) possède une extrémité libre, et dans laquelle chaque contact (40,42) est conique (18) et se rétrécit en formant une pointe à son extrémité libre.

8. Sonde de test électrique selon la revendication 5 ou la revendication 6, caractérisée en ce que chacun desdits contacts (40,42) possède une extrémité libre, et dans laquelle chaque contact (40,42) est pyramidal (28) et se rétrécit en direction d'une surface ayant des dimensions réduites, au niveau de son extrémité libre.
